# EUROPEAN PATENT APPLICATION

(11) **EP 2 388 841 A2**
(43) Date of publication of application: **23.11.2011**
(21) Application number: 09838445.6
(22) Date of filing: 19.11.2009
(51) Int. Cl.: H01L 51/48, H01L 29/78

(54) **SURFACE-TREATED SUBSTRATE FOR AN INKJET PRINTER**

(30) Priority: 15.01.2009 KR 20090003479
(71) Applicant: Postech Academy-industry Foundation, Pohang-si, Gyeongsangbuk-do 790-784 (KR)
(72) Inventor: CHO, Kil Won, Pohang-si Gyungbuk 790-751 (KR); LIM, Jung Ah, Goyang-si Gyeonggi-do 411-320 (KR)
(74) Representative: Ilgart, Jean-Christophe
(86) International application number: PCT/KR2009/006802
(87) International publication number: WO 2010/082724

(57) **Abstract**

The present invention relates to a substrate for inkjet printing of an organic semiconductor and, more particularly, to a substrate for inkjet printing of an organic semiconductor in which the surface energy is controlled in order to form a uniform and crystalline organic semiconductor thin film. The substrate for inkjet printing according to the present invention has the surface of a dielectric layer treated to be hydrophilic, causing the organic semiconductor molecules printed on the substrate to self-assemble with high crystallinity.

## Description

### TECHNICAL FIELD

The present invention relates to a substrate for inkjet printing of an organic semiconductor and, more particularly to, a substrate for inkjet printing of an organic semiconductor in which the surface energy of the substrate is controlled to form a uniform and crystalline organic semiconductor thin film.

### BACKGROUND ART

Many studies have been actively made on organic thin film transistors (OTFTs) as a driving element for next-generation display devices. The OTFT uses organic films instead of silicon films as a semiconductor layer and is classified, based on the type of the organic film material, into low-molecular OTFTs, such as oligothiophene- or pentacene-based OTFTs, and polymer OTFTs, such as polythiophene-based OTFTs.

The organic electroluminescent (EL) display device using OTFTs as a switching element has a matrix of pixels arranged on a substrate, each pixel having two OTFTs, including for example, one switching OTFT and one driving OTFT, one capacitor, and one organic EL element having organic films interposed between upper and lower electrodes.

Generally, a flexible organic EL display device uses a flexible substrate, which includes a plastic substrate. Due to poor thermal stability of the plastic substrate, the organic EL display device using a plastic substrate is necessarily fabricated through a low-temperature process.

The organic thin film transistor (OTFT) using an organic film as a semiconductor layer is acceptable in low-temperature process and hence attracting a considerable attention as a switching element for a flexible organic EL display device.

KR 2004-0028010 A discloses a pentacene thin film transistor that requires a shorter thin film deposition time with enhanced hole mobility. KR 2004-0084427 A describes an OTFT device structure and its fabrication method by which the transistor can have enhanced electrical performances. Besides, JP 2003-092410 A discloses a thin film transistor in which the channel region consists of an organic compound containing radicals to enhance carrier mobility and on/off current ratio.

As those techniques involve a high production cost, there has been a continuous demand for a fabrication process that costs less. The inkjet printing technique, for example, has been brought in the limelight as a direct patterning technique essential to securing a low-cost fabrication process in production of organic electronic devices, such as organic luminescent emission diode (OLED), organic field effect transistor (OFET), or organic solar cell (OSC), or radio-frequency identification (RFID) devices.

WO 99/39373 discloses a method for forming a pattern on a substrate through precipitation of an organic material that involves precipitating an organic material such as an organic semiconductor dissolved in a solvent, such as chloroform, on a substrate by inkjet printing; and drying the solvent off to have the organic material left on the substrate and thereby to form a pattern.

However, the organic semiconductor layer formed through inkjet printing forms non-uniform morphologies on the surface during the drying process with low crystallinity and is thus disadvantageously inferior in performance to the organic semiconductor layer formed through spin coating or deposition.

To solve this problem, there have been developed novel organic semiconductor materials, such as poly(alkylthiophene), oligothiophene or pentacene precursors, and novel approaches for improving printing factors, such as the type of solvents for organic semiconductor, the surface wettability of the substrate, or the concentration of the solution (M. Plotner, T. Wegener, S. Richter, W.J. Fischer, Synthe. Met. 2004, 147, 299; S.K. Volkman, S. Moleda, B. Mattix, P.C. Chang, V. Subramanian, Mater. Res. Soc. Symp. Proc. 2003. 771, 391; P.C. Chang, S.E. Molesa, A.R. Murphy, J.M. J. Frechet, V. Subramanian, IEEE Trans. Electron Devices 2006, 53, 594).

But, the organic semiconductor layer formed by inkjet printing still has unsolved problems that the coffee stain effect during the drying causes difficulty in acquiring uniform morphologies after the drying and, if any uniform morphology, crystallinity hardly appears.

Korean patent application No. 2008-0064335 suggests methods of forming uniform morphologies on the surface after the drying by using a mixture of solvents different from each other in specific viscosity and surface tension.

These methods involve adjusting the composition of a printing ink to control the drying mechanism, which methods undesirably require the use of different solvents according to the type of a semiconductor used.

Accordingly, there has been continuously demanded a novel method for controlling the morphology of a drying inkjet drop.

### DISCLOSURE OF INVENTION

### TECHNICAL PROBLEM

It is an object of the present invention to provide a novel inkjet printing method that is to form an organic semiconductor layer having a uniform thickness after drying.

It is another object of the present invention to provide a substrate for inkjet printing that is to form a uniform organic semiconductor layer after drying.

It is further another object of the present invention to provide a method for processing a substrate for inkjet printing that provides an organic semiconductor layer having a uniform thickness and high crystallinity after drying.

It is still further another object of the present invention to provide a novel organic semiconductor transistor.

It is still further another object of the present invention to provide a method for controlling the surface energy of a substrate.

### TECHNICAL SOLUTION

To achieve the above objects, the present invention provides a method for forming a crystalline semiconductor thin film by dropping an organic semiconductor solution on a hydrophilic surface.

In the present invention, the organic semiconductor solution may be dropped as liquid drops on the surface of a substrate by different methods, preferably by inkjet printing. In an embodiment of the present invention, the inkjet printing device is not specifically limited and may include any product known to those skilled in the art.

If not theoretically limited, in the present invention, the liquid drop of the organic semiconductor solution has a fixed contact diameter in the early stage of drying and, in order to compensate for an evaporation loss, the capillary flow of the solvent is directed from the center of the drop to the contact line on the surface. Hence, crystallization of the organic semiconductor material takes place staring from the contact line, and the molecules carried by the capillary flow interact with one another and self-assemble to form crystals with orientation from the edge of the drop to the center.

In the present invention, the hydrophilic surface may be a layer, such as an insulating layer, on which an organic semiconductor solution is dropped and dried to form an organic semiconductor layer. The insulating layer may include, for example, a dielectric layer for a transistor consisting of a silicon oxide or polymer insulating layer. Preferably, the hydrophilic surface may be a silicon oxide layer.

In one embodiment of the present invention, the surface on which inkjet printing is carried out, such as, for example, a silicon oxide or polymer insulating layer constituting the dielectric layer of a transistor may be completely removed of contaminants through UV-ozone or oxygen plasma surface treatment and become hydrophilized with hydroxide (-OH) groups activated.

In another embodiment of the present invention, the surface on which the inkjet printing is carried out may be realized by forming a self-assembled monolayer having a high surface energy. For example, a mercaptopropyltrimethoxysilane (MPS) layer may be formed on the surface of the silicon oxide layer.

In the present invention, the organic semiconductor may be preferably a low-molecular organic semiconductor in order to have crystallinity after drying. The material for the organic semiconductor layer may be a low-molecular organic semiconductor, such as pentacene (e.g., 6,13-bis(triisopropylsilylethynyl) pentacene (TIPS PEN), tetracene, anthracene, naphthalene, α-6-thiophene, perylene and its derivatives, rubrene and its derivatives, coronene and its derivatives, perylene tetracarboxylic diimide and its derivatives, perylene tetracarboxylic dianhydride and its derivatives, preferably pentacene, more preferably 6,13-bis(triisopropylsilylethynyl)pentacene (TIPS PEN).

In the present invention, the organic semiconductor solution is required to be stably jetted through a nozzle of an inkjet printer. If the jetted drop of the organic semiconductor solution is dried out to leave a ring-shaped thin film, there cannot be acquired uniform crystallinity all over the drop.

In an embodiment of the present invention, the solvent that can be used to form such an organic semiconductor in the form of a ring-shaped thin film may be a combination of a main solvent usable as a conventional solvent for inkjet printing, such as chlorobenzene, and an auxiliary solvent that differs from the main solvent in boiling point and surface tension, such as dodecane.

In another embodiment of the present invention, the solvent having a high boiling point of 200 °C or above and a low vapor pressure, such as tetralin, may be used alone, since the jetted drop hardly forms a ring-shaped thin film after drying in this case.

The method for forming thin films according to the present invention may be chiefly applied to semi-conductive or charge transport materials, factors or devices, and also to optical, electro-optical or electronic devices, FETs, integrated circuits (ICs), TFTs, or OLEDs as obtained using the semi-conductive or charge-transport materials, factors or devices.

The ring-shaped thin films formed in the present invention may be widely used for TFTs or TFT arrays for flat panel display (FPD), radio-frequency identification (RFID) tags, electroluminescent (EL) displays, back lights, semi-conductive or charge-transport materials, factors or devices, EFTs, ICs, TFTs or OLEDs that include thin films fabricated using an ink for inkjet printer.

In one aspect of the present invention, there is provided a method for fabricating an organic semiconductor transistor that includes:

providing a substrate;

forming a gate on the substrate;

forming a gate insulating film on the gate;

forming source and drain electrodes on the gate insulating film;

performing a surface treatment on the insulating film to form a hydrophilic surface; and

dropping and drying an organic semiconductor solution between the source and drain electrodes.

In the present invention, the gate insulating film may be a silicon insulating film, or an organic insulating film. The preferred gate insulating film is a silicon oxide insulating film.

In the present invention, the surface treatment performed on the insulating film to form a hydrophilic surface may be accomplished using UV-ozone or oxygen plasma surface treatment. The surface treatment may also be accomplished by formation of a hydrophilic self-assembled monolayer. The monolayer may include mercaptopropyltrimethoxysilane (MPS).

In the present invention, the hydrophilic gate insulating film has a surface energy of at least 45 mJ/m², preferably at least 50 mJ/m², on the surface after the surface treatment.

As the drop of the organic semiconductor solution is dropped and dried on the surface, crystallization takes place starting from the edge of the drop towards the center. For that reason, in the present invention, the source and drain electrodes may be constructed to form concentric circles separated from each other at a predetermined distance.

In another aspect of the present invention, there is provided a transistor that includes:

a substrate;

a gate provided on the substrate;

a hydrophilic insulating film formed on the gate;

source and drain electrodes formed on the insulating film; and

an organic semiconductor thin film formed between the source and drain electrodes through inkjet printing.

In the present invention, the hydrophilic insulating film may be an insulating film prepared from an insulating film material, such as silicon oxide or polymer, and subjected to UV-ozone or oxygen plasma surface treatment or provided with a self-assembled monolayer, to have a surface energy of at least 45 mJ/m², preferably at least 50 mJ/m², most preferably at least 200 mJ/m². When an organic semiconductor solution is dropped on the surface of the insulating film having such a high surface energy through inkjet printing, if not theoretically limited, the drop of the organic semiconductor solution is dried with its edge pinned on the surface, so the organic semiconductor material crystallizes starting from the edge of the drop and self-assembles.

In the present invention, the organic semiconductor thin film preferably includes 6,13-bis(triisopropylsilylethynyl) pentacene (TIPS PEN) of which the molecules are most likely to form a pi-pi stacking arrangement in a direction parallel to the surface of the dielectric layer.

In the present invention, the source and drain electrodes are preferably fabricated in the form of concentric circles separated from each other at a predetermined distance so that the organic semiconductor material self-assembles from the edge of the inkjet drop to the center while the drop is drying to form a ring-shaped organic semiconductor layer, allowing an effective use of crystallinity occurring from the edge of the drop to the center after the drying. Between the source and drain electrodes is formed a ring-shaped gap.

In another aspect of the present invention, there is provided a method for controlling the crystallinity of a semiconductor thin film by regulating the surface energy of a substrate in a method of forming an organic semiconductor layer using inkjet printing. The crystallinity of the semiconductor thin film increases with an increase in the surface energy of the substrate. Likewise, the lower surface energy of the substrate ends up with the lower crystallinity of the semiconductor thin film.

The surface energy of the substrate depends on the surface treatment method carried out on the surface of the substrate; such as, for example, performing a UV-ozone or oxygen plasma surface treatment or forming a self-assembled monolayer on the surface of the substrate. The UV-ozone or oxygen plasma surface treatment eliminates contaminants from the surface of silicon oxide and activates hydroxide (-OH) groups on the surface to elevate the surface energy. Providing the surface of the substrate with a self-assembled molecule layer having a hydrophilic surface, such as mercaptopropyltrimethoxysilane (MPS), also increases the surface energy of the substrate. In another embodiment, the surface of the substrate may be provided with a self-assembled molecule layer, such as octadecyltrichlorosilane (OTS), 1,1,1,3,3,3-hexamethyldisilazane (HMDS), (1H,1H,2H,2H)-perfluorooctyltrichlorosilane (FDTS) to have a low surface energy.

In one aspect of the present invention, there is provided a substrate for inkjet printing of which the surface with an organic semiconductor solution inkjet-printed on has a surface energy of at least 45 mJ/m², preferably at least 200 mJ/m².

The substrate may be an inorganic layer, such as a silicon oxide layer, or an organic polymer layer; or a self-assembled molecule layer formed on the inorganic/organic layer.

In one aspect of the present invention, there is provided a method for fabricating a substrate for inkjet printing of which the inkjet-printed surface is treated with UV-ozone or oxygen plasma, or provided with a self-assembled monolayer formed from mercaptopropyltrimethoxysilane (MPS).

### ADVANTAGEOUS EFFECTS

The present invention provides a method for controlling the crystallinity of a semiconductor thin film formed from an organic semiconductor through inkjet printing.

The present invention further provides a high-performance organic thin film transistor including an inkjet-printed semiconductor layer, and a thin film having a hydrophilic surface implementing high crystallinity during inkjet printing.

The present invention further provides novel approaches for changing the hydrophobic surface of a substrate into a hydrophilic surface.

### BRIEF DESCRIPTION OF THE DRAWINGS

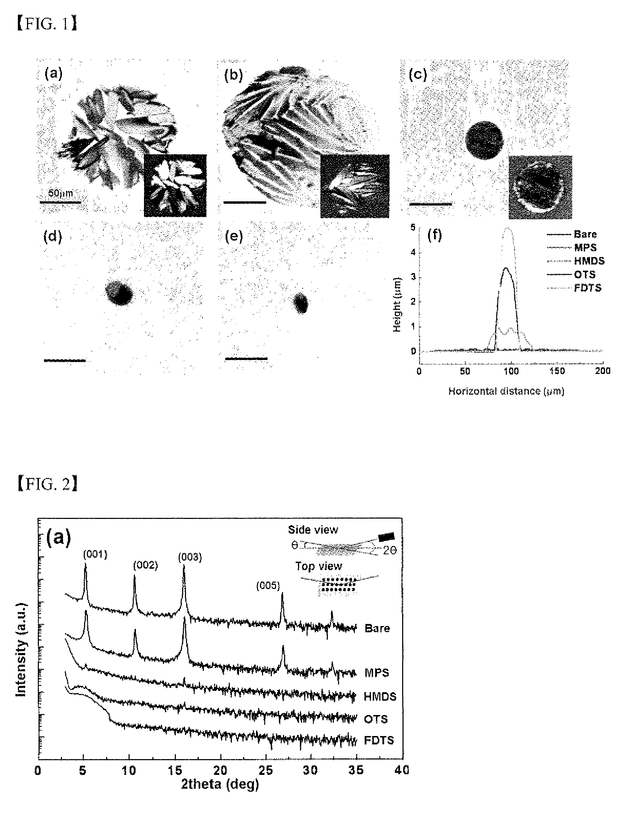

FIG. 1(a) is an optical microscopic (OM) image of a UV-treated silicon oxide surface; FIGS. 1(b) to 1(e) are OM images of a 6,13-bis(triisopropylsilylethynyl) pentacene (TIPS PEN) drop inkjet-printed on a surface treated with MPS, HMDS, OTS or FDTS, respectively, where the scale bar is 50 µm; and FIG. 1(f) is a height profile of single dots of TIPS PEN.

FIG. 2(a) shows out-of-plain X-ray diffraction (θ-2θ) spectra for a TIPS PEN film inkjet-printed on the surface of a dielectric layer treated with different SAMs; and FIG. 2(b) shows out-of-plain X-ray diffraction (θ-2θ) spectra for a TIPS PEN film spin-coated on the surface of a dielectric layer treated with different SAMs.

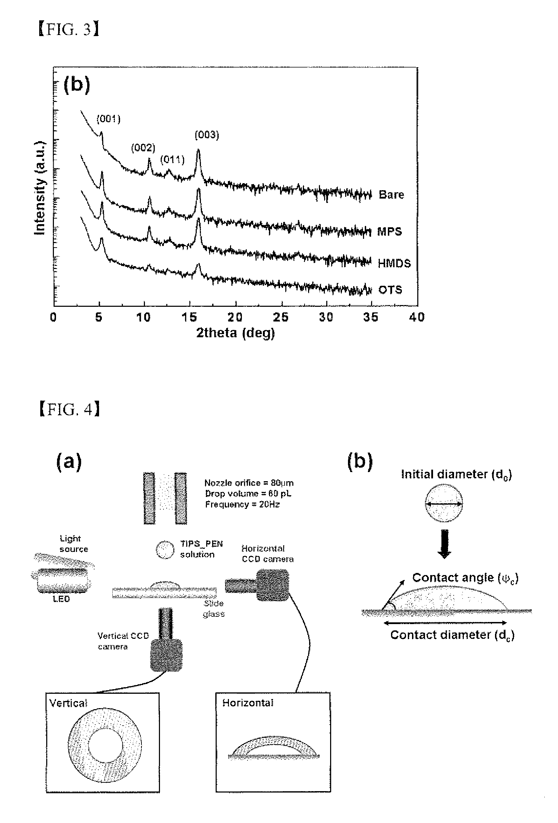

FIG. 3(a) is the geometry of an experimental setup; and FIG. 3(b) is the geometry of a printed drop.

FIG. 4 describes the evaporation process of a single TIPS PEN drop printed on a hydrophilic substrate: FIG. 4(a) presents in-situ time-resolved OM images of an evaporating TIPS PEN drop on the original surface as taken with a vertical CCD camera; FIG. 4(b) shows the time-dependent change in the contact diameter of a drying drop on the original surface and the MPS surface; FIG. 4(c) is a schematic diagram of three stages in the evaporation of the printed TIPS PEN drop; and FIG. 4(d) is a schematic representation of evaporation-mediated self-assembling of TIPS PEN molecules near the contact line of a drying drop.

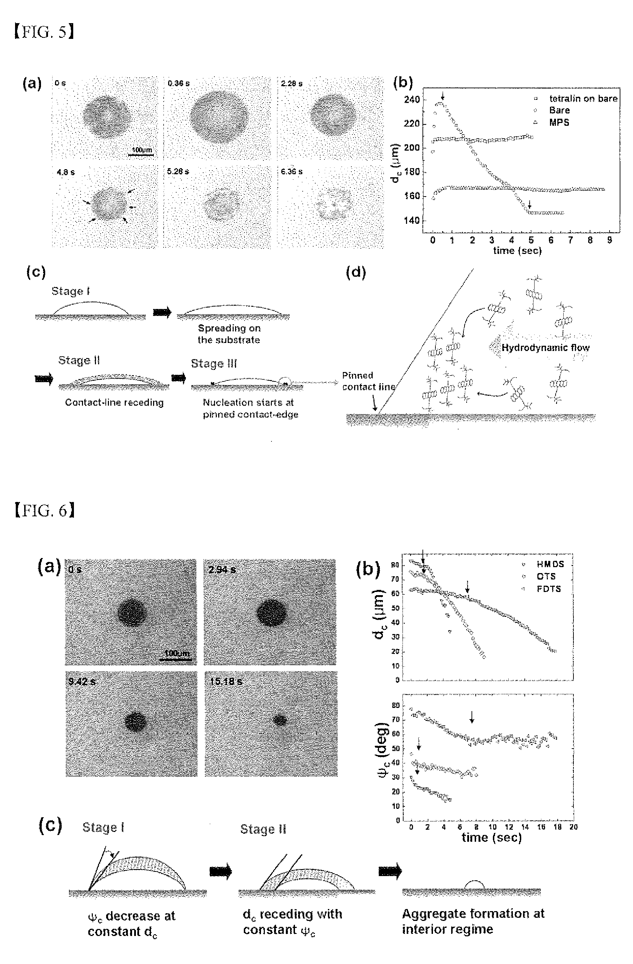

FIG. 5 describes the evaporation process of a single TIPS PEN drop printed on a hydrophobic substrate: FIG. 5(a) presents in-situ time-resolved OM images of a drying TIPS PEN drop on the OTS surface as taken with a vertical CCD camera; FIG. 5(b) shows the time-dependent change in the contact diameter and the contact angle of a drying drop on the HMDS, OTS and FDTS surfaces; and FIG. 5(c) is a schematic representation of two stages in the evaporation of the TIPS PEN drop.

FIG. 6(a) is a polarized OM image of a TIPS PEN transistor inkjet-printed on the surface of a dielectric layer after UV-ozone surface treatment (scale bar = 100 µm); FIG. 6(b) shows the electrical characteristic of the TIPS PEN transistor; and FIG. 6(c) shows the transport characteristic of the TIPS PEN transistor.

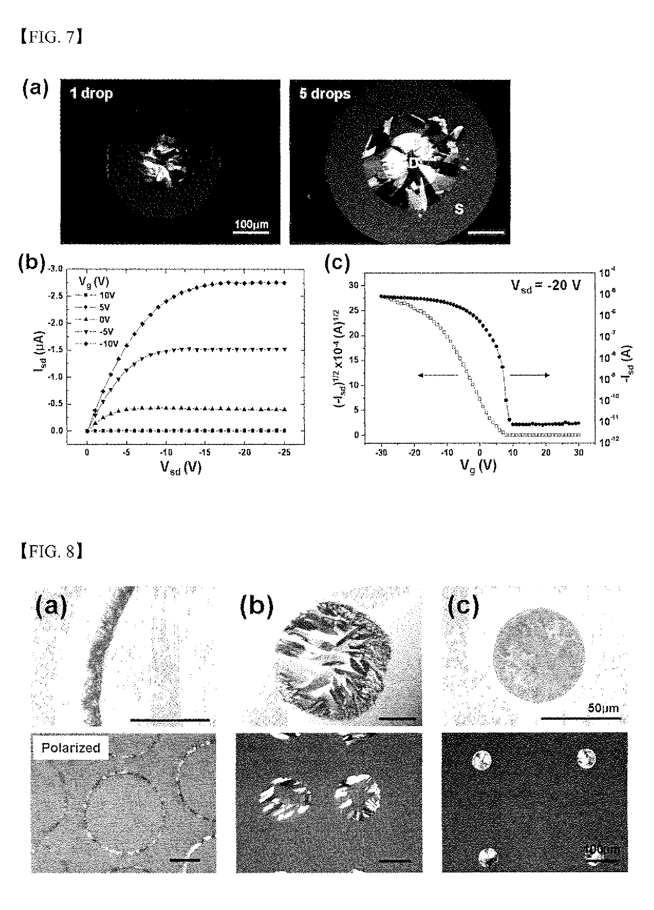

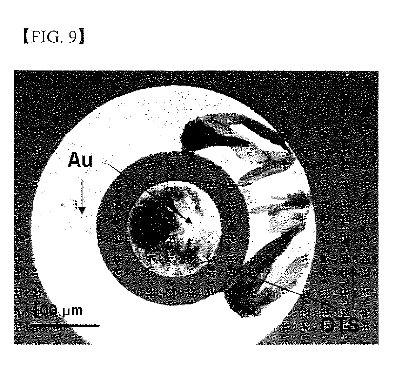

FIG. 7(a), 7(b) and 7(c) are optical microscopic (OM) and polarization microscopic images of an inkjet-printed TIPS PEN drop using different solvents, such as chlorobenzene, tetralin, and 1,2,4-trichlorobenzene, respectively, where the scale bar is 50 µm for optical microscope and 100 µm for polarization microscope.

FIG. 8 shows optical microscopic (OM) images of a TIPS PEN drop inkjet-printed in the OTS-treated channel region.

### BEST MODE FOR CARRYING OUT THE INVENTION

[Example]

Materials

6,13-bis(triisopropylsilylethynyl) pentacene (TIPS PEN) as used herein was prepared and purified according to a known method (John E. Anthony et al.), and mercaptopropyltrimethoxysilane, octadecyltrichlorosilane and trichloro(1H,1H,2H,2H-perfluorooctyl)silane were commercially available. All the alkyl silanes were stored in a desiccator.

A silicon wafer and a cover glass were washed with a piranha solution (70 volume % H₂SO₄ + 30 volume % H₂O₂) at 100 °C for 30 minutes and then again with distilled water. Under argon, the vacuum-dried reaction flask was filled with anhydrous toluene, and the washed silicon wafer or cover glass was placed in the flask. Alkylsilane (10 mM) was put in the flask and left to self-assemble on the wafer for one hour under argon.

The reaction time was 2 minutes for trichloro(1H,1H,2H,2H-perfluorooctyl)silane. The wafer thus surface-treated was washed with toluene and ethanol several times and then baked in an oven at 120 °C for 20 minutes. After baked, the samples were subjected to ultrasonic cleaning in toluene, washed out with ethanol and then dried under vacuum. 1,1,1,3,3,3-hexamethyldisilazane (HMDS) was spin-coated onto the washed substrate and then baked at 150 °C for one hour. The original hydrophilic surface was subjected to 20-minute UV-ozone surface treatment.

Inkjet Printing

A TIPS PEN tetralin solution (1-2 wt.%) was printed on a SAM (Self-Assembled Monolayer)-treated SiO₂ substrate.

A home-built inkjet printer was equipped with a single nozzle drop-on-demand piezoelectric print head (Microfab Jet Drive III), a biaxial motor positioning system, and a CCD camera with LEDs for visualizing the jetting of a drop. A less than 60 pico-liter single drop was jetted on demand through a nozzle having a diameter of 80 µm. The vertical separation distance between the nozzle and the substrate was typically 0.5 mm. The substrate was maintained at the same temperature of the room (26 °C, RH 30%). To visualize the drying behavior of the jetted drop, there was used an SAM-treated glass substrate, with two cameras (0.06 sec./frame) for recording images viewed from bottom and lateral sides, as shown in FIG. 3.

FIG. 1(a) is an optical microscopic (OM) image of a UV-treated silicon oxide surface. FIGS. 1(b) to 1(e) are OM images of a TIPS PEN drop inkjet-printed on a surface treated with MPS, HMDS, OTS or FDTS, respectively, where the scale bar is 50 µm. FIG. 1(f) shows a height profile of single dots of TIPS PEN.

On the UV-treated surface and the different SAM-treated dielectric layers were dropped water and tetralin, and the contact angle of each case was measured. The measurement results as well as the surface energy are presented in Table 1.

**[Table 1]**

| | Surface Treatment | | | | |
|---|---|---|---|---|---|
| | UV alone | MPS | HMDS | OTS | FDTS |
| Water Contact Angle (deg) | < 5 | 54 | 66 | 104 | 107 |
| Tetralin Contact Angle (deg) | < 5 | 12 | 26 | 46 | 68 |
| Surface Energy (mJ/m²) | 287 | 56 | 45 | 28 | 19 |

The surface energy was determined from the contact angle measured using distilled water and diiodomethane as a probe liquid. The geometric mean equation was given by (1 + cosθ)γₚₗ = 2(γ^{d}γ^{d}ₚₗ)^{1/2} + 2(γₛγ^{p}ₚₗ)^{1/2}, where γₛ and γₚₗ were surface energies of the substrate and the probe liquid, respectively; and superscripts d and p refer to the interactive components, that is, dispersive and polar parts of the surface energy, respectively.

On the UV-treated surface and the MPS-treated surface having a high surface energy, as shown in the POM images, there appeared crystals of several scores of micron meters in size with a clear optical contrast, representing uni-axial molecular alignment of crystals. Contrarily, on the HMDS-treated surface, a TIPS PEN aggregate 1 µm high and 50 µm in diameter was observed, with a small amount of crystals on the edge of the deposit, as shown in the POM images. On the OTS- and FDTS-treated surfaces having a lower surface energy than the HMDS-treated surface, concentrated aggregates having a smaller diameter and a greater height appeared, without an optical contrast in the POM image, implementing that there was no crystalline alignment on the micrometer scale.

An X-ray diffraction (XRD) testing was performed to identify the crystalline microstructure of the inkjet-printed TIPS PEN film. With the XRD intensity sensitive to the thickness of the film, the inkjet-printed dots were aligned with a same dot-to-dot distance of less than 30 µm all over the surface in the testing. The results are presented in Table 2.

The XRD spectra of the self-assembled crystals on the UV-treated hydrophilic surface and the MPS-treated surface, in FIG. 2(a), showed only (001) reflection corresponding to the c axis = 16.8 Å on the TIPS PEN unit cell. This means that TIPS PEN molecules had considerably high crystallinity and orientation. In case of spin-coating, there was no difference on the surfaces of different surface energies.

The morphologies of the drops were analyzed with a polarizing optical microscope (POM) (Axioplan, Zesis). The θ/2θ mode X-ray diffraction (XRD) analysis was performed at 10C1 beamlines using a synchrotron source at the PAL (Pohang Accelerator Laboratory) in South Korea. The electrical characteristics of the transistor were determined by plotting the current-voltage curve (Keithley 2400 and 236).

The experimental setup of FIG. 3 was made in order to analyze the self-assembling process of the TIPS-PEN drops inkjet-printed on different surfaces. The images revealed the initial contact angle (Ψ_{c}), contact diameter (d_{c}), and the height of each drop.

FIG. 4(a) shows the variation of the morphology of the TIPS PEN drop inkjet-printed on the hydrophilic surface after UV-ozone surface treatment. The morphology of the TIPS PEN drop changed in three stages, as shown in FIG. 4(c). In the first stage, a TIPS PEN drop was spread over the surface for 0.36 second, soaking the surface. In the second stage, the contact diameter approached the maximum and then declined until the contact line was pinned. With the progress of drying, the contact diameter of the drying drop became constant and TIPS PEN crystallization started at a contact line on the surface. TIPS PEN molecules were self-assembling, and the final aligned crystals were oriented in a direction from the contact line of the drop to the center.

When the contact line of a drying drop got pinned, the drop had a fixed diameter and the capillary flow of the solvent was directed from the center of the drying drop to the contact line in order to compensate for an evaporation loss. The outward capillary flow carried the solute to the edge of the drop, so the TIPS PEN concentration was higher at the contact line of the drop than at the center. Hence, the TIPS PEN concentration near the contact line rather than in the center may approach the concentration required for crystallization, which caused crystallization to occur at the pinned contact line. The molecules supplied by the capillary flow self-assembled through intramolecular pi-pi interactions. This process is illustrated in FIG. 4(d). As shown in FIG. 7, a TIPS PEN solution was inkjet-printed on a silicon oxide substrate after UV-ozone surface treatment, where the TIPS PEN solution used different solvents, such as chlorobenzene, tetralin, and 1,2,4-trichlorobenzene, as shown in FIGS. 4(a), 4(b) and 4(c), respectively. Using the TIPS PEN solution in trichlorobenzene having a higher boiling point (214 °C) than the solution in tetralin caused no ring-shaped deposit, while using the TIPS PEN solution in tetralin ended up with better crystallinity.

The evaporation on a hydrophobic substrate occurs in two stages, as illustrated in FIG. 5: the first stage of maintaining the initial contact diameter with the contact angle decreased; and the second stage of maintaining the contact angle with the contact diameter receding.

Fabrication of OFET Device and Inkjet Printing

A bottom-contact field effect transistor was prepared using an over-doped n-type Si wafer as a gate electrode, and a 300nm-thick thermally oxidized SiO₂ layer (capacitance = 10.8 nF/cm²) as a gate dielectric layer. Normal photolithography was employed to form golden source and drain electrodes in a closed circle layout. The channels had a length (L)/width (W) ratio of 20/829 µm, 50/1570 µm, or 100/2199 µm. A 3nm-thick titanium layer was used for adhesiveness of the golden electrodes. The inkjet-printed TIPS PEN crystals were deposited on the surface of the device that was subjected to 20-minute UV-ozone surface treatment to be hydrophilic. Here, the positioning system of an inkjet printer was used to selectively deposit the TIPS PEN crystals on the patterned electrodes.

As shown in FIG. 8, on the hydrophobic surface, the printed TIPS PEN hardly soaked the channels, causing difficulty of fabricating OFETs, because there was the difference in surface energy between the hydrophobic channel region and the Au electrode.

Contrarily, the TIPS PEN transistor inkjet-printed on the dielectric layer after UV-ozone surface treatment formed TIPS PEN crystals of an oriented crystalline structure even with a single drop. The transistor showed a current of 2.7 µA at a gate voltage of -10 V, with the calculated field effect mobility of 0.08 to 0.15 cm²V⁻¹S⁻¹ and the sub-threshold slope of 0.8 V/decade. The on-ff current ratio exceeded 10⁶. The results are presented in FIG. 6.

## Claims

1. A method for forming a crystalline semiconductor thin film, the method comprising dropping an organic semiconductor solution on a hydrophilic surface.

2. The method as claimed in claim 1, wherein the hydrophilic surface is a dielectric layer of a transistor.

3. The method as claimed in claim 1 or 2, wherein the hydrophilic surface is a surface treated with UV-ozone or oxygen plasma.

4. The method as claimed in claim 3, wherein the hydrophilic surface is a silicon oxide or polymer insulating layer.

5. The method as claimed in claim 1 or 2, wherein the hydrophilic surface has a surface energy of at least 45 mJ/m².

6. The method as claimed in claim 5, wherein the hydrophilic surface is a self-assembled monolayer formed on a dielectric layer.

7. The method as claimed in claim 6, wherein the self-assembled monolayer is mercaptopropyltrimethoxysilane (MPS).

8. The method as claimed in claim 1 or 2, wherein the organic semiconductor solution is dropped through inkjet printing.

9. The method as claimed in claim 8, wherein the organic semiconductor solution has a contact angle of at most 5° with respect to the hydrophilic surface.

10. The method as claimed in claim 8, wherein the organic semiconductor is 6,13-bis(triisopropylsilylethynyl)pentacene.

11. The method as claimed in claim 8, wherein a solvent used for the organic semiconductor solution has a boiling point of at least 200 °C.

12. The method as claimed in claim 11, wherein the solvent is tetralin.

13. A method for fabricating a transistor, comprising:
providing a substrate;
forming a gate on the substrate;
forming a gate insulating film on the gate;
forming source and drain electrodes on the gate insulating film;
performing a surface treatment on the insulating film to form a hydrophilic surface; and
dropping an organic semiconductor solution between the source and drain electrodes and then drying it.

14. The method as claimed in claim 13, wherein the insulating film is a silicon oxide or polymer insulating layer.

15. The method as claimed in claim 13 or 14, wherein the surface treatment is UV-ozone or oxygen plasma treatment.

16. The method as claimed in claim 13 or 14, wherein the surface treatment is forming a self-assembled monolayer.

17. The method as claimed in claim 16, wherein the self-assembled monolayer is mercaptopropyltrimethoxysilane (MPS).

18. The method as claimed in claim 13 or 14, wherein the surface-treated surface has a surface energy of at least 45 mJ/m².

19. The method as claimed in claim 13 or 14, wherein the organic semiconductor solution is dropped through inkjet printing.

20. The method as claimed in claim 13 or 14, wherein the organic semiconductor solution has a contact angle of at most 5° with respect to the surface-treated insulating film.

21. The method as claimed in claim 19, wherein the organic semiconductor is 6,13-bis(triisopropylsilylethynyl)pentacene.

22. The method as claimed in claim 19, wherein a solvent of the organic semiconductor solution is tetralin.

23. The method as claimed in claim 13 or 14, wherein the source and drain electrodes form concentric circles and separate from each other.

24. A transistor comprising:
a substrate;
a gate provided on the substrate;
a hydrophilic insulating film formed on the gate;
source and drain electrodes formed on the insulating film; and
an organic semiconductor thin film inkjet-printed between the source and drain electrodes.

25. The transistor as claimed in claim 24, wherein the insulating film is a silicon oxide or polymer insulating film treated with UV-ozone or oxygen plasma.

26. The transistor as claimed in claim 24 or 25, wherein the insulating film is a silicon oxide insulating film having a self-assembled monolayer formed on the surface thereof.

27. The transistor as claimed in claim 26, wherein the self-assembled monolayer is mercaptopropyltrimethoxysilane (MPS).

28. The transistor as claimed in claim 24, wherein the hydrophilic insulating film has a surface energy of at least 45 mJ/m².

29. The transistor as claimed in claim 24, wherein the hydrophilic insulating film has a surface energy of at least 200 mJ/m².

30. The transistor as claimed in claim 24 or 25, wherein the organic semiconductor is 6,13-bis(triisopropylsilylethynyl) pentacene.

31. The transistor as claimed in claim 30, wherein the source and drain electrodes form concentric circles and separate from each other.

32. A method for forming an organic semiconductor layer using inkjet printing, the method comprising regulating a surface energy of a substrate to control crystallinity of a semiconductor thin film.

33. The method as claimed in claim 32, wherein the crystallinity of the semiconductor thin film is raised by increasing the surface energy of the substrate.

34. A substrate for inkjet printing, the substrate having a surface with an organic semiconductor solution being inkjet-printed thereon, the surface having a surface energy of at least 45 mJ/m²_{.}

35. The substrate for inkjet printing as claimed in claim 34, wherein the surface energy is at least 200 mJ/m².

36. A method for fabricating a substrate for inkjet printing, comprising:
performing UV-ozone or oxygen plasma surface treatment on an inkjet-printed surface of the substrate; or
providing a self-assembled monolayer formed from mercaptopropyltrimethoxysilane (MPS).
